# EUROPEAN PATENT SPECIFICATION

(11) **EP 2 181 976 B1**
(45) Date of publication and mention of the grant of the patent: **28.11.2012**
(21) Application number: 10150516.2
(22) Date of filing: 04.10.2006
(51) Int. Cl.: C04B 35/493, H01L 41/083, H01L 41/187

(54) **Piezoelectric ceramic composition and laminated piezoelectric element**
Piezoelektrische keramische Zusammensetzung und ein laminiertes piezoelektrisches Element
Composition d'une céramique piézoélectrique et un elément piézoélectrique laminé

(30) Priority: 04.10.2005 JP 2005291761; 05.10.2005 JP 2005292637; 21.12.2005 JP 2005367444; 02.03.2006 JP 2006056767; 03.03.2006 JP 2006057079; 08.03.2006 JP 2006063243
(43) Date of publication of application: 05.05.2010
(62) Divisional of application: 06020835.2
(73) Proprietor: TDK Corporation, Tokyo 103-8272 (JP)
(72) Inventor: Iezumi, Kumiko, Tokyo 103-8272 (JP); Yamazaki, Junichi, Tokyo 103-8272 (JP); Tsukada, Takeo, Tokyo 103-8272 (JP); Sakamoto, Norimasa, Tokyo 103-8272 (JP); Sogabe, Tomohiro, Tokyo 103-8272 (JP); Nanao, Masaru, Tokyo 103-8272 (JP)
(74) Representative: HOFFMANN EITLE

(56) References cited:
- EP-A- 1 702 905
- EP-A2- 1 367 036
- JP-A- 2004 137 106

## Description

### BACKGROUND OF THE INVENTION

### Field of the Invention

The present invention relates to laminated piezoelectric element using a piezoelectric ceramic composition and Cu for internal electrodes.

### Description of the Related Art

Piezoelectric ceramic compositions to be used in piezoelectric elements are required to be large in piezoelectric properties, in particular, in piezoelectric strain constant. As piezoelectric ceramic compositions satisfying such properties, there have been developed, for example, a ternary piezoelectric ceramic composition containing lead titanate (PbTiO₃), lead zirconate (PbZrO₃) and lead zincate niobate [Pb(Zn_{1/3}Nb_{2/3})O₃], a piezoelectric ceramic composition in which the Pb in the above-mentioned ternary piezoelectric ceramic composition is partially substituted with Sr, Ba, Ca or the like, and other piezoelectric ceramic compositions.

However, these conventional piezoelectric ceramic compositions require sintering at relatively high temperatures exceeding 1200°C, and undergo sintering in an oxidative atmosphere; consequently, for example, in laminated piezoelectric elements in which internal electrodes are simultaneously sintered, it has been necessary to use noble metals (such as Pt and Pd) that are high in melting point and are not oxidized even when sintered in an oxidative atmosphere. As a result, the increase in cost is caused to offer an obstacle to price reduction of manufactured laminated piezoelectric elements.

Under these circumstances, the present applicant has proposed to enable low temperature sintering by adding a first additive containing at least one selected from Fe, Co, Ni and Cu and a second additive containing at least one selected from Sb, Nb and Ta to the above-mentioned ternary piezoelectric ceramic compositions, and consequently to make low price materials such as a Ag-Pd alloy usable for internal electrodes (see Japanese Patent Laid-Open No. 2004-137106).

The invention of Japanese Patent Laid-Open No. 2004-137106 is such that there is realized a piezoelectric ceramic composition having a high piezoelectric strain constant, and being densified without impairing various piezoelectric properties and being increased in mechanical strength even when sintered at low temperatures, by adding the first additive containing at least one selected from Fe, Co, Ni and Cu, and the second additive containing at least one selected from Sb, Nb and Ta in the above-mentioned ternary piezoelectric ceramic composition and in the piezoelectric ceramic composition in which Pb in the above-mentioned ternary piezoelectric ceramic composition is partially substituted with Sr, Ba, Ca or the like, and there is also provided a piezoelectric element having piezoelectric layers formed by using the thus realized piezoelectric ceramic composition.

EP 1 702 905 A1 relates to a piezoelectric ceramic composition which has as a chief ingredient a composite oxide that has Pb, Ti and Zr as constituent elements. The composition contains as a first accessory ingredient at least one element selected from the group consisting of Mn, Co, Cr, Fe and Ni in an amount of 0.2 mass% or less in terms of an oxide. As the first accessory ingredient, at least one species selected from the ingredients represented by CuOₓ, wherein x 0, can be adopted. In this case, the content of the first accessory ingredient is 3.0 mass% or less.

JP 2004 137106 A relates to a piezoelectric element which has a piezoelectric layer constituted of a piezoelectric porcelain composition which has a high piezoelectric strain constant and enhanced mechanical strength, and can be densified without lowering various piezoelectric characteristics even when it is fired at a low temperature. The porcelain composition has a main component including an oxide of a composition expressed by formula: (Pb_{1-B}Me_{B})_{A}[(Zn_{1/3}Nb_{2/3})ₐTibZr_{c}]O₃, a first sub-component containing at least one selected from among Fe, Co, Ni and Cu, and a second sub-component containing at least one selected from among Sb, Nb, and Ta. In the formula, Me, A, B, a, b and c are at least one selected from Me: Ca, Sr and Ba and satisfy following relations: 0.99<=A<=1.005, 0<=B<=0.1, 0.05<=a<=0.25, 0.35<=b<=0.50, 0.38<=c<=0.48, and a+b+c = 1.

EP 1 367 036 A2 relates to a multilayer piezoelectric element comprising piezoelectric layers composed of a piezoelectric ceramic. The piezoelectric ceramic includes a compound oxide having a perovskite structure which contains at least lead, zirconium and titanium.

### SUMMARY OF THE INVENTION

When internal electrodes are formed with a lower price metal (such as Cu), there occurs a disadvantage such that sintering in an oxidative atmosphere (for example, in air) oxidizes the internal electrodes to impair the conductivity even in a case where the sintering is carried out at a low temperature. To overcome such a disadvantage, the sintering is required to be carried out in a reductive atmosphere having a low oxygen partial pressure (for example, an oxygen partial pressure of the order of 1.013 × 10⁻⁵ to 1.013 × 10⁻¹ Pa (1 × 10⁻¹⁰ to 1 × 10⁻⁶ atm)). However, such sintering in a reductive atmosphere has encountered a problem that the piezoelectric properties are impaired although the oxidation of the internal electrodes themselves can be prevented.

Such sintering in a reductive atmosphere abundantly generates oxygen vacancies in the crystal of a piezoelectric ceramic composition because of the extreme scarcity of oxygen in the atmosphere, as compared to sintering in air. The presence of such oxygen vacancies degrades the electric resistance of the piezoelectric ceramic composition at high temperatures (for example, 150°C). A temperature region about 150°C is sometimes included in a specified operating temperature range of a product, and accordingly, the degradation of the electric resistance of a piezoelectric ceramic composition seriously affects the reliability of the product.

In these years, demand for size reduction and sophistication of various products leads to demand for size reduction and sophistication for actuators to be used in such products. Size reduction of an actuator element while preserving the displacement magnitude thereof necessitates a piezoelectric ceramic composition that has further higher piezoelectric properties. In particular, a development challenge is to search out a piezoelectric ceramic composition that attains high piezoelectric properties even by low temperature sintering.

Accordingly, an object of the present invention is to provide a laminated piezoelectric element using a piezoelectric ceramic composition that does not degrade the piezoelectric properties even when Cu is used as a conductive material for internal electrodes, and further even when low temperature sintering is carried out.

Another object of the present invention is to provide a laminated piezoelectric element using a piezoelectric ceramic composition that can inhibit the degradation of the electric resistance to be caused by the oxygen vacancies due to sintering at low temperatures and in a reductive atmosphere.

The present inventors have investigated the cause for the degradation of the piezoelectric properties in a case where Cu is used as a conductive material for internal electrodes, and have found that Cu diffuses from the internal electrodes into the piezoelectric layers and the grain growth in the piezoelectric layers is inhibited. Consequently, the present inventors have interpreted that the diffusion of Cu into the piezoelectric layers and the insufficient grain growth cause the piezoelectric property degradation.

However, there has been obtained a finding that the presence of Cu in the piezoelectric layers overcomes the electric resistance degradation at high temperatures.

To enjoy the advantageous effect, due to the presence of Cu, of overcoming the degradation of the electric resistance at high temperatures, the use of Ag₂O is also effective against the degradation of the piezoelectric properties; Ag₂O contributes to the improvement of the piezoelectric properties through lowering the sintering temperature. When Ag₂O is added alone, the electric resistance and the insulation life tend to be degraded with increasing Ag₂O content; however, the concomitant presence of Cu has prevented the electric resistance degradation due to Ag₂O. It has been revealed that in a piezoelectric ceramic composition containing Cu and Ag₂O, the improvement degree of the piezoelectric properties at high voltages (1 to 3 kV/mm) is more remarkable than the improvement degree of the piezoelectric properties at low voltages (1 V/mm or lower).

Because a laminated piezoelectric element is driven at high voltages (1 to 3 kV/mm), it is necessary to attain satisfactory piezoelectric properties at high voltages. There are two or more physical property values to evaluate the piezoelectric properties; however, when laminated piezoelectric elements are used, the electromechanical coupling coefficient kr (%) and the displacement magnitude are significant. Because it is cumbersome to evaluate materials by giving the materials displacements at such high voltages, usually displacements are not measured, but actually a simple impedance measurement and a measurement with a d33 meter are carried out at a low voltage (1 V/mm or lower). By assuming that the piezoelectric properties at a low voltage and the piezoelectric properties at a high voltage link with each other, evaluation of the piezoelectric ceramic compositions has hitherto been carried out. However, as described above, the present invention has found that the improvement of the piezoelectric properties at high voltages is remarkable.

Consequently, the present invention provides a laminated piezoelectric element comprising:
(a) a plurality of piezoelectric layers comprising a piezoelectric ceramic composition comprising:
   (i) as a main constituent thereof a composite oxide represented by the formula A:

      (Pb_{a-b}Me_{b}) [(Zn_{1/3}Nb_{2/3})ₓTiyZr_{z}] O₃

      wherein
      0.96 ≤ a ≤1.03,
      0 ≤ b ≤ 0.1,
      0.05 ≤ x ≤ 0.15,
      0.25 ≤ y ≤ 0.5,
      0.35 ≤ z ≤ 0.6, and
      x + y + z = 1, and
      Me is at least one of Sr, Ca and Ba;
   (ii) 0.01 to 1.0 wt.-% of Cu in terms of Cu₂O in relation to the composite oxide (i); and
   (iii) 0.01 to 0.5 wt.-% of Ag in terms of Ag₂O, in relation to the composite oxide (i). and
(b) a plurality of internal electrode layers formed between the piezoelectric layers and comprising Cu wherein the Cu contained in the internal electrode layers has diffused into the piezoelectric layers.

The piezoelectric ceramic composition preferably contains Cu in a content of 0.01 to 0.8% by mass in terms of Cu₂O, and Ag in a content of 0.01 to 0.4% by mass in terms of Ag₂O, in relation to the main constituent.

The piezoelectric ceramic composition preferably contains at least one selected from Ta, Sb, Nb and W in a content of 0.5% by mass or less (not inclusive of 0) in terms of oxide.

The laminated piezoelectric element of the present invention includes a plurality of piezoelectric layers containing a composite oxide as the main constituent and a plurality of Cu-containing internal electrode layers formed between the piezoelectric layers, wherein the piezoelectric layers are formed of a sintered body containing: the composite oxide represented by the composition formula A as the main constituent; and Cu in a content of 0.01 to 1.0% by mass in terms of Cu₂O, and Ag in a content of 0.01 to 0.5% by mass in terms of Ag₂O, in relation to the main constituent.

In this case, the Cu contained in a part or the whole of the piezoelectric layers can be derived from the diffusion during sintering of a part of the Cu contained in the internal electrode layers.

The above-mentioned laminated piezoelectric element can be obtained by involving a sintering step for sintering a laminate in which composite oxide-containing piezoelectric layer precursors and Cu-containing internal electrode precursors are laminated with each other, wherein: the piezoelectric layer precursors contain the composite oxide represented by the composition formula A as the main constituent, and Ag in a content of 0.01 to 0.5% by mass in terms of Ag₂O in relation to the main constituent; and the Cu contained in the internal electrode precursors is diffused into the piezoelectric layers in the sintering step.

In the above-mentioned production method of a laminated piezoelectric element, sintering can be carried out at a sintering temperature of 800 to 1200°C under an oxygen partial pressure of 1.013 × 10⁻⁵ to 1.013 × 10⁻¹ Pa (1 × 10⁻¹⁰ to 1 × 10⁻⁶ atm).

As described above, according to the present invention, even when a low-price metal material, namely, Cu is used as a conductive material for the internal electrodes, it is possible to provide a piezoelectric ceramic composition high in piezoelectric properties such as the electromechanical coupling coefficient kr (%). Consequently, according to the present invention, it is possible to provide a laminated piezoelectric element that is excellent in piezoelectric properties although low in price. In particular, the present invention can attain a specific advantageous effect that the diffusion of Cu into the piezoelectric layers improves the piezoelectric properties.

Further, the present invention provides a laminated piezoelectric element using a piezoelectric ceramic composition that can inhibit the electric resistance degradation caused by the oxygen vacancies due to sintering at a low temperature in a reductive atmosphere.

### BRIEF DESCRIPTION OF THE DRAWINGS

FIG. 1 is a view illustrating a construction example of a laminated piezoelectric element in an embodiment of the present invention;
FIG. 2 is a flow chart showing production procedures of the laminated piezoelectric element in an embodiment of the present invention;
FIG. 3 shows a TEM image and EDS point analysis results of a piezoelectric layer in the vicinity of an internal electrode layer in a laminated piezoelectric element obtained by using Cu in the internal electrode layer;
FIG. 4 is a table showing the compositions, and the measurement results of the electric resistance in Example 1;
FIG. 5 is a table showing the compositions, and the electromechanical coupling coefficients kr (%), the d values, the (d/kr)/(d_{STD}/kr_{STD}) values, and the resistivity at 150°C in Example 2;
FIG. 6 is a table showing the compositions, the d values, and the (d/kr)/(d_{STD}/kr_{STD}) values in Example 3;
FIG. 7 is a table showing the compositions, the d values, and the (d/kr)/(d_{STD}/kr_{STD}) values in Example 4;
FIG. 8 is a table showing the compositions, the d values, and the (d/kr)/(d_{STD}/kr_{STD}) values in Example 5;
FIG. 9 is a table showing the compositions, the d values, and the (d/kr)/(d_{STD}/kr_{STD}) values in Example 6;
FIG. 10 is a table showing the compositions, the d values, and the (d/kr)/(d_{STD}/kr_{STD}) values in Example 7;
FIG. 11 is a table showing the compositions, the d values, and the (d/kr)/(d_{STD}/kr_{STD}) values in Example 8;
FIG. 12 is a table showing the compositions, the d values, the (d/kr)/(d_{STD}/kr_{STD}) values, and the resistivity values at 150°C in Example 9;
FIG. 13 is a table showing the compositions, the d values, the (d/kr)/(d_{STD}/kr_{STD}) values, and the resistivity values at 150°C in Example 10;

### DETAILED DESCRIPTION OF THE PREFERRED EMBODIMENTS

Detailed description will be made below on the present invention on the basis of the embodiments shown in the accompanying drawings.

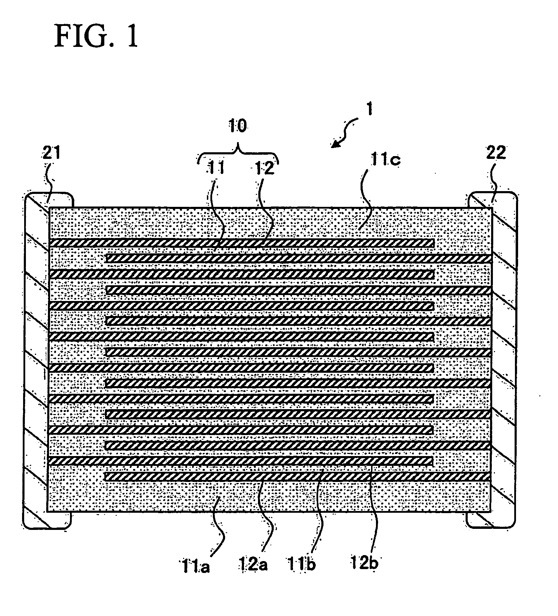

FIG. 1 is a sectional view illustrating a construction example of a laminated piezoelectric element 1 of the present invention. FIG. 1 shows one example, and needless to say, the present invention is not limited to the laminated piezoelectric element 1 shown in FIG. 1. The laminated piezoelectric element 1 has a laminate 10 in which a plurality of piezoelectric layers 11 and a plurality of internal electrode layers 12 are alternately laminated with each other. The thickness of one piezoelectric layer 11 is set at, for example, 1 to 200 µm, preferably at 20 to 150 µm, and more preferably at 50 to 100 µm. The lamination number of the piezoelectric layers 11 is determined according to the targeted displacement magnitude.

The piezoelectric ceramic composition forming the piezoelectric layers 11 contains as a main constituent a composite oxide that contains Pb, Ti and Zr as the constituent elements. Examples of the composite oxide include a ternary composite oxide constituted with lead titanate (PbTiO₃), lead zirconate (PbZrO₃) and lead zincate niobate [Pb(Zn_{1/3}Nb_{2/3})O₃], and a composite oxide in which the Pb contained in the above-mentioned ternary composite oxide is partially substituted with Sr, Ba, Ca or the like.

The specific compositions of the composite oxides are represented by the following formula wherein the composition of the oxygen is derived stoichiometrically; in the actual compositions, deviations from the stoichiometric compositions are allowed.

(Pb_{a-b}Me_{b}) [(Zn_{1/3}Nb_{2/3})ₓTi_{y}Zr_{z})O₃ (2)

wherein 0.96 ≤ a ≤ 1.03, 0 < b ≤ 0.1, 0.05 ≤ x ≤ 0.15, 0.25 ≤ y ≤ 0.5, 0.35 ≤ z ≤ 0.6, and x + y + z = 1, Me representing at least one selected from Sr, Ca and Ba.

The above-mentioned composite oxide has a so-called perovskite structure, wherein Pb and the substitutional element Me in formula (2) are located at the so-called A site in the perovskite structure, and Zn, Nb, Ti and Zr are located at the so-called B site in the perovskite structure.

In each of the composite oxides represented by above formula (2), the A-site element ratio (molar ratio) "a" satisfies the relation that 0.96 ≤ a ≤ 1.03 with the B-site molar ratio assumed to be 1. If the A-site element ratio "a" is less than 0.96, sintering at low temperatures may become difficult. If the A-site element ratio "a" exceeds 1.03, the density of the piezoelectric ceramic to be obtained may be degraded, which may result in poor piezoelectric properties and a lower mechanical strength. The A-site element ratio "a" preferably satisfies the relation that 0.97 ≤ a ≤ 1.02, and more preferably 0.98 ≤ a ≤ 1.01.

In the composite oxide represented by above formula (2), Pb is partially substituted with the substitutional element Me (Sr, Ca, Ba), and the piezoelectric strain constant can thereby be made larger. However, when the substitution amount b of the substitutional element Me becomes too large, the piezoelectric strain constant becomes smaller and the mechanical strength is also degraded. The Curie temperature also tends to be decreased with the increase of the substitution amount b. Consequently, the substitution amount b of the substitutional element Me is set at 0.1 or less, and preferably set to satisfy 0.005 ≤ b ≤ 0.08, and more preferably 0.007 ≤ b ≤ 0.05.

Among the B-site elements, the ratio (molar ratio) x of Zn and Nb is set to satisfy 0.05 ≤ x ≤ 0.15. The ratio x affects the sintering temperature. If the value of x is less than 0.05, the effect of lowering the sintering temperature may be insufficient. If the value of x exceeds 0.15, the sinterability is affected by such a x value, leading to a fear that the piezoelectric strain constant becomes small and the mechanical strength is degraded. The ratio x of Zn and Nb preferably satisfies 0.07 ≤ x ≤ 0.13 and more preferably 0.08 ≤ x ≤ 0.12.

Among the ratios of the B-site elements, the preferable ranges for the ratio y (molar ratio) of Ti and the ratio z (molar ratio) of Zr are set from the viewpoint of the piezoelectric properties. Specifically, the ratio y of Ti satisfies 0.25 ≤ y ≤ 0.5, and the ratio z of Zr satisfies 0.35 ≤ z ≤ 0.6. By setting these ratios to fall within the above-mentioned ranges, there can be obtained a large piezoelectric strain constant in the vicinity of the morphotropic phase boundary (MPB). The ratio y of Ti preferably satisfies 0.3 ≤ y ≤ 0.48, and preferably 0.4 ≤ y ≤ 0.46. The ratio z of Zr preferably satisfies 0.37 ≤ z ≤ 0.55, and more preferably 0.4 ≤ z ≤ 0.5.

The above descriptions give the fundamental structure of the laminated piezoelectric element 1 of the present invention.

The piezoelectric ceramic composition used in the laminated piezoelectric of the present invention may contain additive in addition to the main constituent. This additive (the fourth additive) includes at lest one selected from Ta, Sb, Nb and W. The addition of this additive can improve the piezoelectric properties and the mechanical strength. However, the content of this additive is preferably 1.0% by mass or less in terms of oxide. For example, the content of Ta is 1.0% by mass or less in terms of Ta₂O₅, the content of Sb is 1.0% by mass or less in terms of Sb₂O₃, the content of Nb is 1.0% by mass or less in terms of Nb₂O₅, and the content of W is 1.0% by mass or less in terms of WO₃. If the content of this additive exceeds 1.0% by mass in terms of oxide, the sinterability may be lowered and the piezoelectric properties may be thereby degraded. The content of the fourth additive is more preferably 0.05 to 0.8% by mass, and furthermore preferably 0.1 to 0.5% by mass.

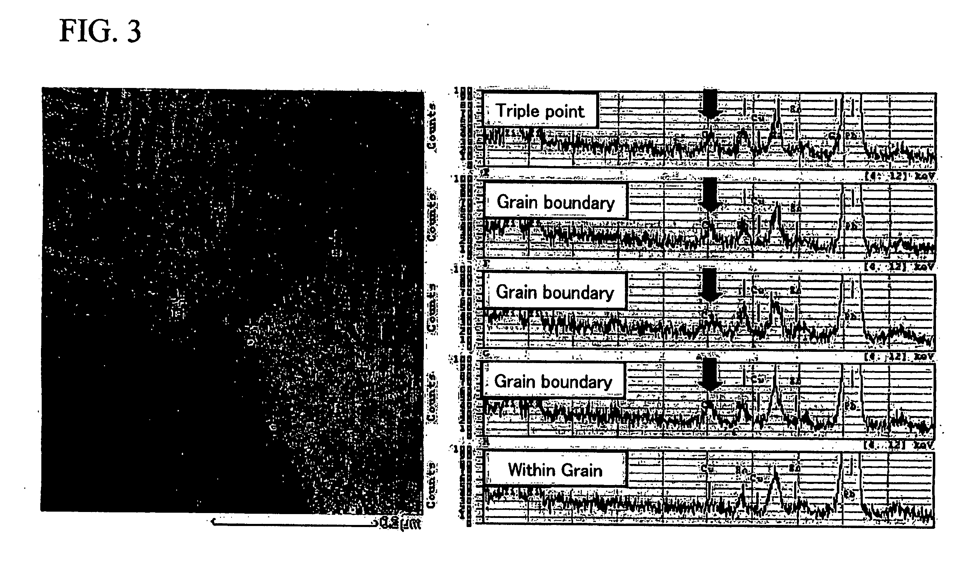

A laminated piezoelectric element 1 has been prepared by using Cu for the internal electrode layers 12, and the piezoelectric layers 11 in the vicinity of the internal electrode layers 12 have been subjected to an analysis based on TEM-EDS (field-emission type transmission electron microscope with energy dispersive X-ray spectroscopy). FIG. 3 shows a TEM image and point analysis results based on EDS. Cu is present at the triple points and the grain boundaries in the piezoelectric layers 11, and thus, it has been found that Cu diffuses from the internal electrode layers 12 in the sintering process. The Cu is present as CuOα (α ≥ 0) in the piezoelectric layers 11. When CuO_{α} (α ≥ 0) is present as described above in the piezoelectric layers 11, the electric resistance degradation at high temperatures is inhibited and the high temperature load life is improved.

The CuO_{α} (α ≥ 0) contained in the piezoelectric layers 11 may be generated by the diffusion of the Cu contained in the internal electrode layers 12 into the piezoelectric layers 11, or may be contained by adding CuO_{α} to the piezoelectric layers 11 at the time of preparing the raw material composition thereof. In the present invention as claimed, it is essential that the piezoelectric layers 11 contain Cu, which has diffused into the layers from the internal electrode layers.

Here, description will be made on the experiment for identifying the effect due to the diffusion of Cu into the piezoelectric layers 11.

A piezoelectric ceramic composition has been prepared as follows. First, as the raw materials for the main constituent, a PbO powder, a SrCO₃ powder, a ZnO powder, a Nb₂O₅ powder, a TriO₂ powder and a ZrO₂ powder were prepared, and were weighed out to give the following composition. Then, these raw materials were wet mixed in a ball mill for 16 hours, and the mixture thus obtained was calcined in air at 700 to 900°C for 2 hours. Main constituent:

(Pb_{0.995-0.03}Sr_{0.03}) [(Zn_{1/3}Nb_{2/3})_{0.1}Ti_{0.43}Zr_{0.47}]O₃

The calcined mixture thus obtained was pulverized, and then wet milled in a ball mill for 16 hours. The milled mixture was dried, added with an acrylic resin as a binder, and then granulated. The granulated mixture was compacted into a disc of 17 mm in diameter and 1 mm in thickness with a uniaxial press molding machine under a pressure of approximately 445 MPa. After compacting, a Cu paste containing a Cu powder of 1.0 µm in particle size was printed on both sides of this disc. The pellet thus obtained was heat treated to evaporate the binder, and sintered at 950°C for 8 hours in a low-oxygen reductive atmosphere (oxygen partial pressure: 1.013 × 10⁻⁵ to 1.013 × 10⁻¹ Pa ( 1 × 10⁻¹⁰ to 1 × 10⁻⁶ atm)). The sintered body thus obtained was subjected to slicing machining and lapping machining into a 0.6 mm thick disc; then the printed Cu paste was removed and at the same time machined into a shape suitable for the property evaluation. A silver paste was printed on both sides of the obtained sample, and baked at 350°C. The sample was subjected to a polarization treatment in a silicone oil set at 120°C by applying an electric filed of 3 kV for 15 minutes.

A piezoelectric ceramic composition was prepared by following the above described method, and another piezoelectric ceramic composition for which no Cu paste printing was carried out was prepared. The two piezoelectric ceramic compositions thus prepared were subjected to a measurement of electric resistance (resistivity, hereinafter the same) IR and further a measurement of the electromechanical coupling coefficient kr (%). The measurement of the electromechanical coupling coefficient kr (%) was carried out by using an impedance analyzer (HP4194A, manufactured by Hewlett-Packard Co.). The results thus obtained are shown below. It may be noted that the electric resistance IR (relative value) means a value obtained by dividing the resistance value at 150°C of each of the piezoelectric ceramic compositions by the resistance value at 150°C for the case where no Cu paste coating was carried out.
With Cu paste: Electric resistance IR (relative value) = 124, kr (%) = 66.1%
Without Cu paste: Electric resistance IR (relative value) = 1, kr (%) = 66.5%

As can be seen, in the piezoelectric ceramic composition printed with a Cu paste, the electric resistance at a high temperature has been drastically improved. However, the piezoelectric property (electromechanical coupling coefficient kr (%)) has been somewhat decreased.

The piezoelectric ceramic composition printed with a Cu paste was subjected to ICP (Inductively Coupled Plasma) analysis. A preparation method of a sample for ICP was as follows: first, 0.1 g of an analyte sample was added with 1 g of Li₂B₂O₇, and the mixture was melted at 1050°C for 15 minutes; the obtained molten was added with 0.2 g of (COOH)₂ and 10 ml of HCl, heated to be dissolved, and then the sample solution volume was adjusted so as to be 100 ml. The ICP measurement was carried out by using ICP-AES (trade name ICPS-8000, manufactured by Shimadzu Corp.). Consequently, it was found that Cu was contained in a content of approximately 0.1% by mass in terms of CuO. The Cu can be identified to have diffused from the Cu paste during the sintering process, because no Cu was contained in the raw materials of the piezoelectric ceramic composition.

Next, description will be made on the experiment for identifying the effect due to the addition of Cu as a component of the piezoelectric layers.

As the raw materials for the main constituent, a PbO powder, a SrCO₃ powder, a ZnO powder, a Nb₂O₅ powder, a TiO₂ powder and a ZrO₂ powder were prepared, and were weighed out to give the following composition. Then, these raw materials were wet mixed for 16 hours in a ball mill, and the mixture thus obtained was calcined in air at 700 to 900°C for 2 hours.
Main constituent:

(Pb_{0.995-0.03}Sr_{0.03})[(Zn_{1/3}Nb_{2/3})_{0.1}Ti_{0.43}Zr_{0.47}]O₃

The calcined mixture thus obtained was pulverized, added with CuO, and then wet milled for 16 hours in a ball mill. The milled mixture was dried, added with a vehicle, and then kneaded to prepare a piezoelectric layer paste. An internal electrode layer paste was also prepared by kneading a Cu powder as the conductive material with a vehicle. Then, by using the piezoelectric layer paste and the internal electrode layer paste, a green chip to be a precursor for a laminate was prepared by means of a printing method. The green chip was subject to a binder removal treatment, and then sintered under reductive sintering conditions to yield a laminate. The reductive sintering conditions were such that sintering was carried out in a reductive atmosphere (for example, under an oxygen partial pressure: 1.013 × 10⁻⁵ to 1.013 × 10⁻¹ Pa (1 × 10⁻¹⁰ to 1 × 10⁻⁶ atm)) at temperatures of 800 to 1200°C.

The obtained laminate was subjected to the electric resistance IR (relative value) measurement at a high temperature in the same manner as described above and a measurement of the dielectric constant ε. The results obtained are shown below.

Laminated body: Electric resistance IR (relative value) = 112, dielectric constant ε = 1646.

Bulk body: Electric resistance IR (relative value) = 124, dielectric constant ε = 1995.

The addition of Cu to the piezoelectric layers has drastically improved the electric resistance at a high temperature in the same manner as in the case where Cu was diffused from the internal electrode layers into the piezoelectric layers. And, the accompanying decrease of the dielectric constant ε has been identified to be small.

Next, the piezoelectric layers 11 containing CuO_{α} (α ≥ 0) degrade the piezoelectric properties, and hence the present invention contains Ag in a content of 0.01 to 0.5% by mass in terms of Ag₂O. Here, by containing Cu in the piezoelectric layers 11, the electric resistance degradation due to the reductive sintering and the addition of Ag is inhibited. However, if the content of Cu becomes too large, the piezoelectric properties may be degraded, and hence the content of Cu is set at 0.01 to 1.0% by mass in terms of Cu₂O; the content of Cu is preferably 0.01 to 0.8% by mass, and more preferably 0.02 to 0.5% by mass, in terms of Cu₂O. Examples of the form of occurrence of Cu may include the Cu oxides having arbitrary oxidation states such as Cu₂O and CuO, and metallic Cu; two or more of these species may be contained.

As described above, the Cu contained in the piezoelectric layers 11 may be generated by the diffusion of the Cu contained in the internal electrode layers 12 into the piezoelectric layers 11, or may be contained in the piezoelectric layers 11 by adding as, for example, Cu₂O to the precursors of the piezoelectric layers 11; And, these two ways of containing Cu may be combined. In the present invention, it is essential that the piezoelectric layers 11 contain Cu, which has diffused into the layers from the internal electrode layers.

In the above case, the piezoelectric layers 11 contain Ag in a content of 0.01 to 0.5% by mass in terms of Ag₂O. Ag (Ag₂O) is effective for low temperature sintering, and is effective, by being contained together with Cu, in improving the piezoelectric properties at high voltages (1 to 3 kV/mm). On the other hand, the present invention inhibits the electric resistance degradation encountered when only Ag₂O is contained, by the concomitant presence of Cu.

However, when the content of Ag becomes too large, the improvement effect of the piezoelectric properties at high voltages cannot be attained, and hence the content of Ag is set at 0.01 to 0.5% by mass in terms of Ag₂O. The content of Ag is preferably 0.01 to 0.4% by mass, and more preferably 0.02 to 0.35% by mass in terms of Ag₂O.

The internal electrode layers 12 contain a conductive material. The present invention uses Cu as the conductive material. The use of Cu as the conductive material is useful for the low temperature sintering, for example, at 1050°C or lower.

The plurality of internal electrode layers 12 are alternately extended in opposite directions, and a pair of terminal electrodes 21 and 22 are disposed to be electrically connected to the alternate extension ends of the internal electrode layers 12, respectively. The terminal electrodes 21 and 22 are, for example, electrically connected to an external power supply not shown in the figure through the lead wires not shown in the figure.

The terminal electrodes 21 and 22 may be formed by sputtering with Cu, or alternatively, by baking a paste for the terminal electrodes. The thickness of each of the terminal electrodes 21 and 22 is appropriately determined depending on the intended purposes and other factors, and is usually 10 to 50 µm.

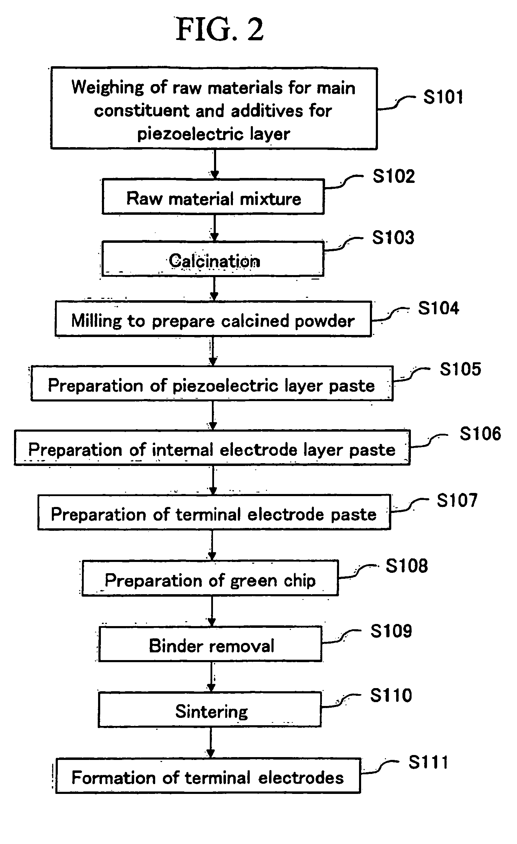

Next, description will be made on a preferable production method of the laminated piezoelectric element 1 with reference to FIG. 2. FIG. 2 is a flow chart showing a production process of the laminated piezoelectric element 1.

First, as the starting materials for the main constituent for the purpose of obtaining the piezoelectric layers 11, for example, the following are prepared and weighed out: the powders of PbO, TiO₂, ZrO₂, ZnO and Nb₂O₅, or the compounds that can be converted into these oxides by sintering; and the powder of at least one oxide selected from SrO, BaO and CaO or one selected from the compounds that can be converted into these oxides by sintering and the like (step S101). As the starting materials, instead of oxides, such materials as carbonates and oxalates that are converted into oxides by sintering may also be used. The raw material powders having an average particle size of 0.5 to 10 µm are usually used.

Each of the starting materials for the additives is prepared according to need and weighed out (step S101). As the starting materials for the additives, instead of oxides, such materials as carbonates and oxalates that are converted into oxides by sintering may also be used as described above.

Subsequently, the starting materials for the main constituents and the additives are wet milled and mixed, for example, in a ball mill to yield the raw material mixture (step S102).

The starting materials for the additives may be added before the calcination (step S103) to be described below, or may be added after the calcination. It is to be noted that the addition before the calcination is preferable because the more homogeneous piezoelectric layers 11 can thereby be prepared; when added after calcination, oxides are preferably used for the starting materials for the additives.

Next, the raw material mixture is dried and calcined, for example, at temperatures of 750 to 950°C for 1 to 6 hours (step S103). This calcination may be carried out in air, in an atmosphere having an oxygen partial pressure higher than that in air, or in an atmosphere of pure oxygen. After calcination, the calcined mixture is wet milled and mixed, for example, in a ball mill to yield a calcined powder containing the main constituent and, if needed, additive(s) (step S104).

Next, the calcined powder is added with a binder to prepare a piezoelectric layer paste (step S105). Specifically, the involved procedures are as follows: first, for example, in a ball mill, a slurry is prepared by wet milling; at this time, as the solvent for the slurry, water, alcohols such as ethanol, or a mixed solvent composed of water and ethanol can be used; and the wet milling is preferably carried out until the average particle size of the calcined powder becomes approximately 0.5 to 2.0 µm.

Next, the obtained slurry is dispersed in an organic vehicle. The organic vehicle means a mixture in which a binder is dissolved in an organic solvent. No particular constraint is imposed on the binders usable for the organic vehicle; such a binder may be appropriately selected from common various binders such as ethyl cellulose, polyvinyl butyral and acryls. Also, no particular constraint is imposed on the organic solvent concerned; such a solvent may be appropriately selected from organic solvents such as terpineol, butylcarbitol, acetone, toluene, and MEK (methyl ethyl ketone), according to the method to be applied such as printing and sheet forming.

When the piezoelectric layer paste is made to take a form of an aqueous coating composition, the calcined powder may be kneaded with an aqueous vehicle in which a water-soluble binder, a water-soluble dispersant or the like is dissolved in water. No particular constraint is imposed on the water-soluble binder to be used for the aqueous vehicle; for example, polyvinyl alcohol, cellulose, a water-soluble acrylic resin or the like may be used.

Additionally, the internal electrode layer paste is also prepared (step S106).

The internal electrode layer paste is prepared by kneading the above-mentioned various conductive materials or various oxides, organometallic compounds, resinates and the like to be converted after sintering into the above-mentioned conductive materials, with the above-mentioned organic vehicle.

In the sintering step to be described below, the Cu contained in the internal electrode layer paste diffuses into the piezoelectric layers 2 to be formed by sintering of the piezoelectric layer paste. In this diffusion, the particle size of the Cu contained in the internal electrode layer paste affects the diffusion quantity. When the particle size of the Cu contained in the internal electrode layer paste is large, the diffusion quantity is increased; when the particle size of the Cu is small, the diffusion quantity is decreased. For the purpose of preventing the decrease of the piezoelectric strain constant, the smaller diffusion quantity of the Cu is the more preferable. Accordingly, it is preferable that the particle size of Cu contained in the internal electrode layer paste is as small as possible.

A terminal electrode paste is also prepared in the same manner as the internal electrode layer paste (step S107).

In the above-mentioned case, the piezoelectric layer paste, the internal electrode layer paste and the terminal electrode paste are prepared sequentially in this order; however, needless to say, these pastes may be simultaneously prepared or in a reversed order.

No particular constraint is imposed on the content of the organic vehicle in each of the pastes; the typical content may be such that the content of the binder is approximately 5 to 10% by mass and the content of the solvent is approximately 10 to 50% by mass. Additionally, each of the pastes may contain additives selected from various dispersants, plasticizers, dielectrics, insulators and the like.

Next, by using the above-mentioned pastes, a green chip (laminate) to be sintered is prepared (step S108).

When the green chip is prepared by means of a printing method, the piezoelectric layer paste is printed two or more times, in a predetermined thickness for each time, for example, on a substrate made of polyethylene terephthalate and the like, to form an outer piezoelectric layer 11a in a green state. Then, on the outer piezoelectric layer 11a in a green state, the internal electrode layer paste is printed in a predetermined pattern to form an internal electrode layer (an internal electrode layer precursor) 12a in a green state. Then, on the internal electrode layer 12a in a green state, the piezoelectric layer paste is printed two or more times, in a predetermined thickness for each time, in the same manner as described above, to form a piezoelectric layer (a piezoelectric layer precursor) 11b in a green state. Then, on the piezoelectric layer 11b in a green state, the internal electrode layer paste is printed in a predetermined pattern, to form an internal electrode layer 12b in a green state. The internal electrode layers 12a and 12b each in a green state are formed so as to be exposed respectively to the different end surfaces facing each other. The above-mentioned operations are repeated predetermined number of times, and finally, on the internal electrode layer 12 in a green state, the piezoelectric layer paste is printed, in the same manner as described above, predetermined number of times, in a predetermined thickness for each time, to form the outer piezoelectric layer 11c in a green state. Hereafter, the laminate thus obtained is pressurized and bonded while being heated, and then cut into a predetermined shape to form a green chip (laminate).

In the above case, description is made on the preparation of a green chip by means of a printing method; however, such a green chip can also be prepared by means of a sheet forming method.

Next, the green chip is subjected to a binder removal treatment (step S109).

In the binder removal treatment, the atmosphere of the binder removal is needed to be determined according to the conductive material in the internal electrode layer precursor. When a noble metal is used as the conductive material, the binder removal may be carried out in air, in an atmosphere having an oxygen partial pressure higher than that in air, or in an atmosphere of pure oxygen. When Cu is used as the conductive material, it is necessary to consider the oxidation, and a heating in a reductive atmosphere is to be adopted. On the other hand, in the binder removal treatment, it is necessary to consider the fact that the oxide contained in the piezoelectric layer precursor, for example, PbO is reduced. For example, when Cu is used as the conductive material, it is preferable to determine what reductive atmosphere is to be applied to the binder removal treatment on the basis of the equilibrium oxygen partial pressure of Cu and Cu₂O (hereinafter, simply referred to as the equilibrium oxygen partial pressure of Cu) and the equilibrium oxygen partial pressure of Pb and PbO (hereinafter, simply referred to as the equilibrium oxygen partial pressure of Pb).

When the binder removal treatment temperature is lower than 300°C, the binder removal cannot be carried out smoothly. Also, when the binder removal treatment temperature exceeds 650°C, no binder removal effect commensurate with such a high temperature can be obtained to result in a waste of energy. The binder removal treatment time is needed to be determined according to the temperature and the atmosphere; the binder removal treatment time can be selected to fall within a range from 0.5 to 50 hours. Further, the binder removal treatment may be carried out separately and independently from the sintering, or may be carried out continuously with the sintering. When the binder removal treatment is carried out continuously with the sintering, the binder removal treatment may be carried out in the course of the temperature elevation in sintering.

After the binder removal treatment, the sintering (step S110) is carried out.

The laminated piezoelectric element 1 is preferably sintered under reductive sintering conditions. In the preparation of the laminated piezoelectric element 1, sintering in an oxidative atmosphere necessitates, for example, the use of a noble metal as the electrode material for the internal electrode layers 12. On the contrary, the laminated piezoelectric element 1 is a product obtained by sintering in the reductive sintering conditions, and hence low price Cu can be used for the internal electrode layers 12 in the present invention. The reductive sintering conditions are, for example, such that the sintering temperature is 800°C to 1200°C and the oxygen partial pressure is 1.013 × 10⁻⁵ to 1.013 × 10⁻¹ Pa (1 × 10⁻¹⁰ to 1 × 10⁻⁶ atm).

When the sintering temperature is lower than 800°C, the sintering does not proceed to a sufficient extent. When the sintering temperature exceeds 1200°C, the melting of Cu is feared. The sintering temperature is preferably 850 to 1100°C and more preferably 900 to 1050°C.

When the oxygen partial pressure is less than 1 × 10⁻¹⁰ atm, there is a fear that the oxide contained in the piezoelectric layer precursor, for example, PbO is reduced, metallic Pb is thereby deposited, and the piezoelectric properties of the finally obtained sintered body are degraded. When the oxygen partial pressure exceeds 1.013 × 10⁻¹ Pa (1 × 10⁻⁶ atm), the oxidation of Cu as the electrode material is feared. The oxygen partial pressure is preferably 1.013 × 10⁻⁴ to 1.013 × 10⁻² Pa (1 × 10⁻⁹ to 1 × 10⁻⁷ atm) and more preferably 1.013 x 10⁻³ to 1.013 × 10⁻² Pa (1 × 10⁻⁸ to 1 × 10⁻⁷ atm).

When the sintering is carried out under the above described reductive sintering conditions, the degradation of the electric resistance at high temperatures becomes an issue; however, in the case of the laminated piezoelectric element of the present invention, this issue can be avoided by containing CuO_{α} (α ≥ 0) in the piezoelectric layers 11 as described above. In other words, the laminated piezoelectric element 1 of the present invention is a product obtained by sintering under the reductive sintering conditions, and hence Cu can be used for the internal electrode layers 12. In addition to this, the degradation of the high temperature load life accompanying the degradation of the electric resistance can be eliminated. Additionally, the degradation of the piezoelectric properties caused by containing CuO_{α} (α ≥ 0) in the piezoelectric layers 11 can be avoided by containing a predetermined content of a rare earth metal element.

The laminate 10 prepared by carrying out the above-mentioned steps is subjected to end face polishing by means of, for example, barrel polishing or sandblast, and then the terminal electrodes 21 and 22 are formed by printing or baking the above-mentioned terminal electrode paste (step S111). The terminal electrodes 21 and 22 can also be formed by sputtering instead of printing or baking.

In the above described manner, the laminated piezoelectric element 1 shown in FIG. 1 can be obtained.

### [Examples]

Hereinafter, the present invention will be described on the basis of specific Examples.

### <Example 1>

Examples 1 to 10 describe the examples of the improvement of the high temperature electric resistance due to the presence of CuO_{α} and the examples of the improvement of the piezoelectric property due to the addition of the third additive.

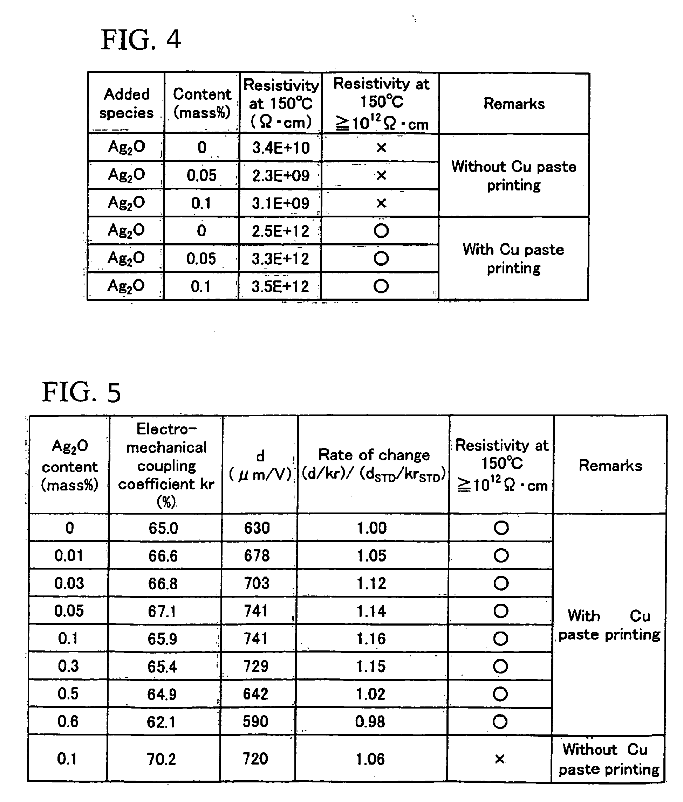

In present Example, Ag, as the third additive, was added so as to give the contents in terms of Ag₂O shown in FIG. 4, in relation to the main constituent shown below, and the effects of the addition of Ag were examined.

Main constituent:

(Pb_{0.995-0.03}Sr_{0.03}) [(Zn_{1/3}Nb_{2/3})_{0.1}Ti_{0.43}Zr_{0.47}]O₃

Each of the piezoelectric ceramic compositions shown in FIG. 4 was prepared as follows. First, as the raw materials for the main constituent, a PbO powder, a SrCO₃ powder, a ZnO powder, a Nb₂O₅ powder, a TiO₂ powder and a ZrO₂ powder were prepared, and were weighed out to give the above-mentioned composition of the main constituent. Ag₂O was prepared as the added species of Ag, and was added to the base composition of the main constituent so as to give the contents shown in FIG. 4. A Ta₂O₅ powder was also added to the base composition of the main constituent in a content of 0.2% by mass. Then, these raw materials were wet mixed with a ball mill for 16 hours, and calcined in air at 700 to 900°C for 2 hours.

The calcined mixture thus obtained was pulverized, and then wet milled with a ball mill for 16 hours. The milled mixture was dried, combined with an acrylic resin as a binder, and then granulated. The granulated mixture was compacted into a disc of 17 mm in diameter and 1 mm in thickness with a uniaxial press molding machine under a pressure of approximately 445 MPa.

After compacting, a Cu paste containing a Cu powder of 1.0 µm in particle size was printed on both sides of the disc. The sample thus obtained was heat treated to evaporate the binder, and sintered at 950°C for 8 hours in a reductive atmosphere (oxygen partial pressure: 1.013 × 10⁻⁵ to 1.013 × 10⁻¹ Pa (1 × 10⁻¹⁰ to 1 × 10⁻⁶ atm)).

The sintered body thus obtained was sliced and lapped into a 0.6 mm thick disc; then the printed Cu paste was removed and at the same time machined into a shape suitable for the property evaluation. A silver paste was printed on both sides of the obtained sample, and baked at 350°C. The sample was subjected to a polarization treatment in a silicone oil set at 120°C by applying an electric field of 3 kV for 15 minutes. Additionally, other samples were prepared in the same manner as described above, inclusive of the polarization treatment, except that neither Cu paste printing nor heat treatment for evaporating the binder was carried out.

The samples thus prepared were subjected to the measurement of the resistivity at 150°C. The results thus obtained are shown in FIG. 4. In FIG 4, "E+0n" in the column for the resistivity means "× 10ⁿ". Accordingly, for example, "2.3E+09" in FIG. 4 means "2.3 × 10⁹" and, for example, "3.5E+12" means "3.5 × 10¹²".

As can be seen from FIG. 4, the measurement results of the sample for which no Cu paste was printed show that the addition of Ag₂O decreases the resistivity. On the contrary, by printing the Cu paste, the resistivity at 150°C was found to be 1 × 10¹² Ω·cm or more; thus, the addition of Ag₂O can inhibit the decrease of the electric resistance.

The sample printed with a Cu paste was subjected to ICP analysis. A preparation method of a sample for ICP was as follows: first, 0.1 g of an analyte sample was combined with 1 g of Li₂B₂O₇, and the mixture was melted at 1050°C for 15 minutes; the obtained molten mixture was combined with 0.2 g of (COOH)₂ and 10 ml of HCl, heated for dissolution, and then the sample solution volume was adjusted to 100 ml. The ICP measurement was carried out by using ICP-AES (trade name ICPS-8000, manufactured by Shimadzu Corp.). Consequently, it was found that Cu was contained in a content of 0.1% by mass in terms of Cu₂O. The Cu can be identified to have diffused from the Cu paste during the sintering process, because no Cu was contained in the raw materials of the piezoelectric ceramic composition.

### <Example 2>

In present Example, samples were prepared, inclusive of the polarization treatment, in the same manner as in Example 1 except that the composition of the raw materials was adjusted so as for Ag to have the contents in terms of Ag₂O shown in FIG. 5, in relation to the main constituent shown below. Additionally, another sample for which no Cu paste was printed was also prepared.

Main constituent:

(Pb_{0.995-0.03}Sr_{0.03}) [(Zn_{1/3}Nb_{2/3})_{0.1}Ti_{0.43}Zr_{0.47}]O₃

The samples thus prepared were subjected to the displacement magnitude measurement at a high voltage and the electromechanical coupling coefficient kr (%) measurement at a low voltage, according to the following procedures.

The displacement magnitude of each of the samples at a high voltage was measured by applying a voltage of 1.7 kV/mm to the sample and by measuring the resulting displacement with a laser Doppler displacement gauge. The displacement magnitude of each of the samples along the direction vertical to the electrode surfaces per 1 mm of the element at the applied voltage of 1.7 kV/mm was represented by D[µm/mm], and the displacement magnitude per unit voltage, d, was derived from d = D × 1000/1.7.

The electromechanical coupling coefficient kr (%) measurement was carried by using an impedance analyzer (HP4194A, 0.2 V/mm, manufactured by Hewlett-Packard Co.).

Here, d and kr (%) of the sample in which Ag₂O was not added are represented by d_{STD} and kr_{STD}, respectively. For each of the other samples, the (d/kr)/(d_{STD}/kr_{STD}) value was derived; the values (rates of change in FIG. 5) derived by using this formula indicate the degree of the piezoelectric property improvement at the high voltage as compared to the sample in which Ag₂O was not added.

The results obtained as described above are shown in FIG. 5.

As shown in FIG. 5, the addition of Ag₂O increases the electromechanical coupling coefficient kr (%) at the low voltage by approximately 3% at a maximum. The addition of Ag₂O can improve the displacement magnitude d and the (d/kr)/(d_{STD}/kr_{STD}) at the high voltage by 15% or more. Thus, the addition of Ag₂O remarkably improves the piezoelectric properties at the high voltage. However, when the content of Ag₂O reaches 0.6% by mass, d and (d/kr)/(d_{STD/}kr_{STD}) become smaller than when Ag₂O is not added. Accordingly, in the present invention, the content of Ag is set at 0.01 to 0.5% by mass terms of Ag₂O. The content of Ag is preferably 0.01 to 0.4% by mass and more preferably 0.02 to 0.35% by mass, in terms of Ag₂O.

### <Example 3>

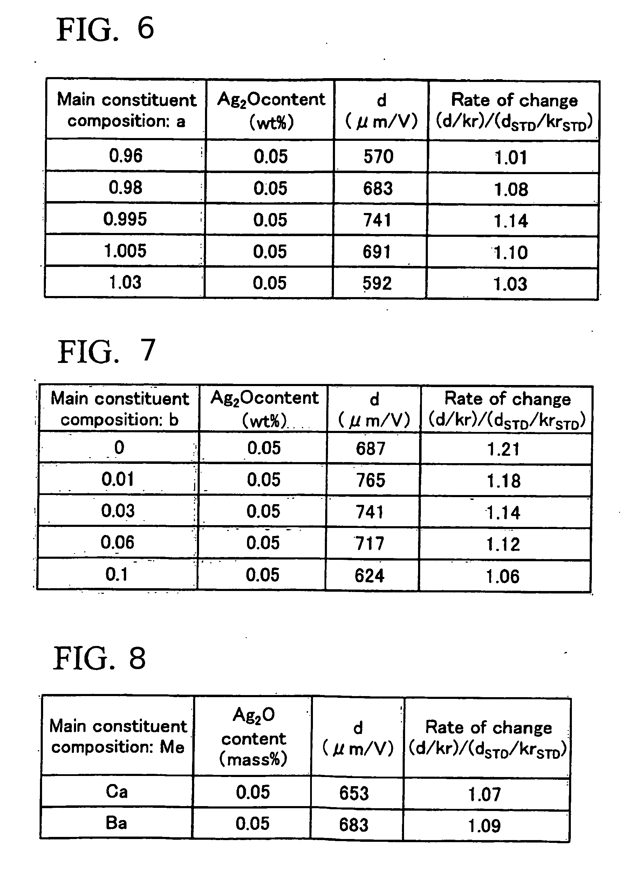

Samples were prepared in the same manner as in Example 1 except that the composition of the raw materials was adjusted so as for "a" to have the values shown in FIG. 6 and so as for Ag to have the content in terms of Ag₂O shown in FIG. 6, in relation to the main constituent shown below. The samples thus obtained were subjected to the evaluation of the d values and the (d/kr(%))/(d_{STD/kr}(%)_{STD}) values in the same manner as in Example 2. The results thus obtained are shown in FIG. 6. It is to be noted that the d_{STD}/kr(%)_{STD} values of the respective samples are the values obtained for the samples in which "a" in the main constituent was such that a = 0.96, 0.98, 0.995, 1.005 and 1.03, and Ag₂O was not contained.

Main constituent:

(Pb_{a-0.03}Sr_{0.03})[(Zn_{1/3}Nb_{2/3})_{0.1}Ti_{0.43}Zr_{0.47}]O₃

As shown in FIG. 646, when "a" falls within the range from 0.96 to 1.03, the piezoelectric properties at the high voltage can be ensured. Preferably "a" is 0.97 to 1.02, and more preferably "a" is 0.98 to 1.01.

### <Example 444>

Samples were prepared in the same manner as in Example 1 except that the composition of the raw materials was adjusted so as for b to have the values shown in FIG. 7 and so as for Ag to have the content in terms of Ag₂O shown in FIG. 7, in relation to the main constituent shown below. The samples thus obtained were subjected to the evaluation of the d values and the (d/kr)/(d_{STD}/kr_{STD}) values in the same manner as in Example 2. The results thus obtained are shown in FIG. 7. It is to be noted that the d_{STD}/kr_{STD} values of the respective samples are the values obtained for the samples in which b in the main constituent was such that b = 0, 0.01, 0.03, 0.06 and 0.1, and Ag₂O was not contained.

Main constituent:

(Pb_{0.995-b}Sr_{b})[(Zn_{1/3}Nb_{2/3})_{0.1}Ti_{0.43}Zr_{0.47}]O₃

As shown in FIG. 7, when b falls within the range from 0 to 0.1, the piezoelectric properties at the high voltage can be ensured.

### <Example 5>

Samples were prepared in the same manner as in Example 1 except that the composition of the raw materials was adjusted so as for Me to be the elements shown in FIG. 8 and so as for Ag₂O to have the contents shown in FIG. 8, in relation to the main constituent shown below. The samples thus obtained were subjected to the evaluation of the d values and the (d/kr)/(d_{STD}/kr_{STD}) values in the same manner as in Example 2. The results thus obtained are shown in FIG. 8.

Main constituent:

(Pb_{0.995-0.03}Me_{0.03}) [(Zn_{1/3}Nb_{2/3})_{0.1}Ti_{0.43}Zr_{0.47}]O₃

As shown in FIG. 8, even when Ca or Ba is used as the substitutional element for Pb, similarly to the case where Sr is used, the improvement effect on the piezoelectric properties at the high voltage can also be enjoyed. It is to be noted that the d_{STD}/kr(%)_{STD} values of the respective samples are the values obtained for the samples in which Me in the main constituent was Ca or Ba, and Ag₂O was not contained.

### <Example 6>

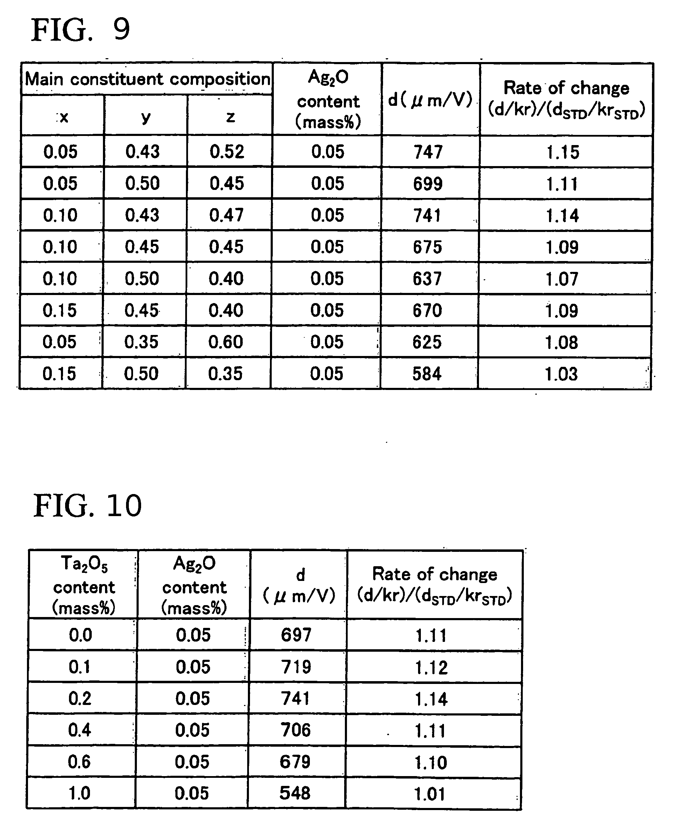

Samples were prepared in the same manner as in Example 1, except that the composition of the raw materials was adjusted so as for x, y and z to have the values shown in FIG. 9 and so as for Ag to have the content in terms of Ag₂O shown in FIG. 9, in relation to the main constituent shown below. The samples thus obtained were subjected to the evaluation of the d values and the (d/kr)/(d_{STD}/kr_{STD}) values in the same manner as in Example 2. The results thus obtained are shown in FIG. 9.

Main constituent:

(Pb_{0.995-0.03}Sr_{0.03}) [(Zn_{1/3}Nb_{2/3})ₓTi_{y}Zr_{z}]O₃

As can be seen from FIG. 9, when x, y and z for the B-site elements fall within the ranges of 0.05 ≤ x ≤ 0.15, 0.25 ≤ y ≤ 0.5 and 0.35 ≤ z ≤ 0.6, respectively, the improvement effect on the piezoelectric properties at the high voltage can be enjoyed. It is to be noted that the d_{STD}/kr_{STD} values of the respective samples are the values obtained for the samples which did not contain Ag₂O.

### <Example 7>

Samples were prepared in the same manner as in Example 1, except that the composition of the raw materials was adjusted so as for Ag and Ta, as the additives, to have the contents in terms of Ag₂O and Ta₂O₅, respectively, shown in FIG. 10, in relation to the main constituent shown below. The samples thus obtained were subjected to the evaluation of the d values and the (d/kr)/(d_{STD}/kr_{STD}) values in the same manner as in Example 2. The results thus obtained are shown in FIG. 10.

Main constituent:

(Pb_{0.995-0.03}Sr_{0.03})[(Zn_{1/3}Nb_{2/3})_{0.1}Ti_{0.43}Zr_{0.47}]O₃

As shown in FIG. 10, the addition of Ta₂O₅, as an additive, can improve d and (d/kr)/(d_{STD}/kr_{STD}). However, when the content of Ta₂O₅ exceeds 0.5% by mass, d and (d/kr)/(d_{STD}/kr_{STD}) are degraded. Accordingly, when Ta₂O₅ is contained, the content of Ta₂O₅ is set at 0.5% by mass or less. The content of Ta₂O₅ is preferably 0.05 to 0.4% by mass and more preferably 0.15 to 0.35% by mass. It is to be noted that the d_{STD}/kr_{STD} values of the respective samples are the values obtained for the samples which did not contain Ag₂O.

### <Example 8>

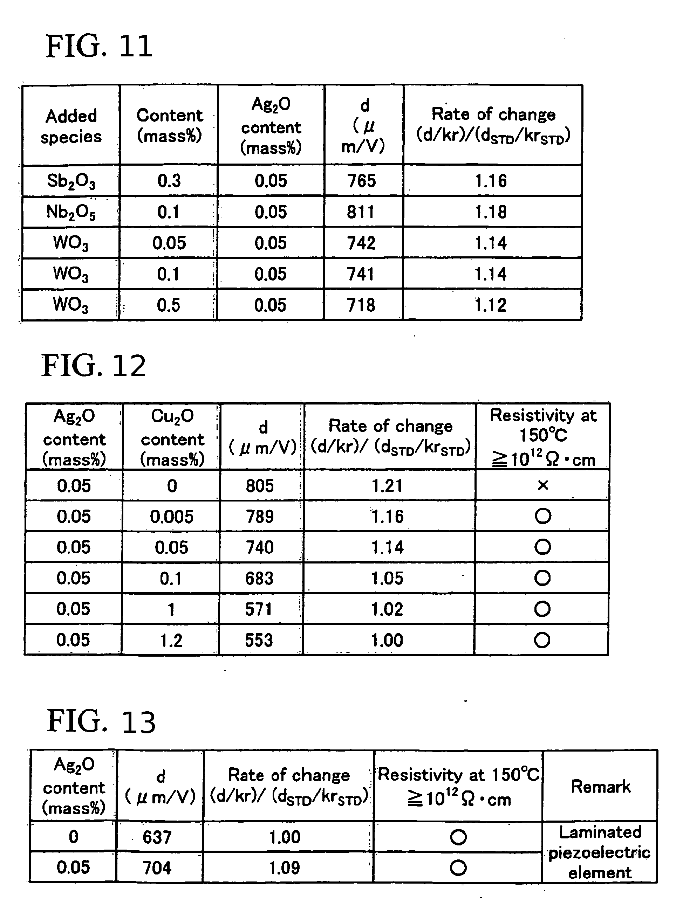

Samples were prepared in the same manner as in Example 1, except that the composition of the raw materials was adjusted to give the contents shown in FIG. 11, in relation to the main constituent shown below. The samples thus obtained were subjected to the evaluation of the d values and the (d/kr)/(d_{STD}/kr_{STD}) values in the same manner as in Example 2. The results thus obtained are shown in FIG. 11.

Main constituent:

(Pb_{0.995-0.03}Sr_{0.03}) [Zn_{1/3}Nb_{2/3})_{0.1}Ti_{0.43}Zr_{0.47}]O₃

As shown in FIG. 11, the addition of Sb₂O₃, Nb₂O₅ or WO₃, as the additive, can also enjoy the improvement effect on the piezoelectric properties at the high voltage. It is to be noted that the d_{STD}/kr_{STD} values of the respective samples are the values obtained for the samples which did not contain the added species shown in FIG. 11.

### <Example 9> (outside the invention as defined in claim 1)

Samples were prepared, inclusive of sintering and polarization, in the same manner as in Example 1, except that the calcined mixtures were combined with Cu₂O in the contents shown in FIG. 12, the main constituent of each of the samples being as shown below. It is to be noted that no Cu paste printing was carried out. The samples thus obtained were subjected to the evaluation of the d values and the (d/kr)/(d_{STD}/kr_{STD}) values in the same manner as in Example 2. The results thus obtained are shown in FIG. 12.

Main constituent:

(Pb_{0.995-0.03}Sr_{0.03}) (Zn_{1/3}Nb_{2/3})_{0.1}Ti_{0.43}Zr_{0.47}]O₃

As shown in FIG. 12, the addition of Cu (Cu₂O) can also enjoy the improvement effect on the piezoelectric properties at the high voltage, in a way other than the diffusion of Cu into the sintered body. However, when the content of Cu₂O reaches 1.2% by mass, the (d/kr)/(d_{STD}/kr_{STD}) value becomes 1 to give no difference from a piezoelectric ceramic composition in which Ag₂O and Cu₂O were not added. Accordingly, in the present invention, the content of Cu is set at 0.01 to 1.0% by mass in terms of Cu₂O. It is to be noted that the content of Cu in terms of Cu₂O in each of the samples was the same as the content of added Cu₂O.

### <Example 10>

Example 10 presents an example of the preparation of a laminated piezoelectric element.

In the preparation of a laminated piezoelectric element, first, a calcined mixture (Ag₂O: 0.05% by mass) obtained in Example 1 was pulverized. The piezoelectric ceramic composition powder thus obtained was combined with a vehicle, and kneaded to yield a piezoelectric layer paste. An internal electrode layer paste was also prepared by kneading a Cu powder as the conductive material with a vehicle. Then, by using the piezoelectric layer paste and the internal electrode layer paste, a green chip as a precursor for a laminate was prepared by means of a printing method. The lamination number of the piezoelectric layer paste was set at 300. The green chip was subject to a binder removal treatment, and then sintered under reductive sintering conditions to yield a laminate. The reductive sintering conditions were such that sintering was carried out in a reductive atmosphere (oxygen partial pressure: 1.013 × 10⁻⁵ to 1.013 × 10⁻¹ Pa (1 × 10⁻¹⁰ to 1 × 10⁻⁶ atm)) at sintering temperatures of 800 to 1200°C. For comparison, another laminate was prepared in the same manner as described above except that Ag₂O was not added.

The laminates thus obtained were subjected to the evaluation of the d values and the (d/kr)/(d_{STD}/kr_{STD}) values in the same manner as in Example 2. The results thus obtained are shown in FIG. 13.

## Claims

1. A laminated piezoelectric element comprising:
(a) a plurality of piezoelectric layers comprising a piezoelectric ceramic composition comprising:
(i) as a main constituent thereof a composite oxide represented by the formula
(Pb_{a-b}Me_{b})[(Zn_{1/3}Nb_{2/3})ₓTi_{y}Zr_{z}]O₃
Wherein
0.96 ≤ a ≤ 1.03,
0 ≤ b ≤ 0.1,
0.05 ≤ x ≤ 0.15,
0.25 ≤ y ≤ 0.5, 0.35 ≤ z ≤ 0.6, and
x+y+z= 1, and
Me is at least one of Sr, Ca and Ba;
(ii) 0.01 to 1.0 wt.-% of Cu in terms of Cu₂O in relation to the composite oxide (i); and
(iii) 0.01 to 0.5 wt.-% of Ag in terms of Ag₂O, in relation to the composite oxide (i). and
(b) a plurality of internal electrode layers formed between the piezoelectric layers and comprising Cu wherein the Cu contained in the internal electrode layers has diffused into the piezoelectric layers.

2. The laminated piezoelectric element of claim 1, wherein the piezoelectric ceramic composition comprises 0.01-0.8 wt.-% of Cu in terms of Cu₂O.

3. The laminated piezoelectric element of claim 1, wherein the piezoelectric ceramic composition comprises 0.02-0.5 wt.-% of Cu in terms of Cu₂O.

4. The laminated piezoelectric element of claim 1, wherein the piezoelectric ceramic composition comprises 0.01-0.4 wt.-% of Ag in terms of Ag₂O.

5. The laminated piezoelectric element of claim 1, wherein the piezoelectric ceramic composition comprises 0.02-0.35 wt.-% of Ag in terms of Ag₂O.

## Patentansprüche

1. Laminiertes, piezoelektrisches Element, umfassend:
(a) eine Mehrzahl piezoelektrischer Schichten, die eine piezoelektrische Keramikzusammensetzung umfassen, die folgendes umfasst:
(i) als Hauptbestandteil ein Mischoxid der Formel
(Pb_{a-b}Me_{b})[(Zn_{1/3}Nb_{2/3})ₓTi_{y}Zr_{z}]o₃,
worin
0,96 ≤ a ≤ 1,03,
0 ≤ b ≤ 0, 1,
0,05 ≤ x ≤ 0,15,
0,25 ≤ y ≤ 0,5,
0,35 ≤ z ≤ 0,6 und
x + y + z = 1 und
Me mindestens eines von Sr, Ca und Ba ist;
(ii) 0,01 bis 1,0 Gew.% an Cu, bezogen auf Cu₂O, im Hinblick auf das Mischoxid (i); und
(iii) 0,01 bis 0,5 Gew.% an Ag, bezogen auf Ag₂O, in Bezug auf das Mischoxid (i) und
(b) eine Mehrzahl innerer Elektrodenschichten, die zwischen den piezoelektrischen Schichten gebildet sind und Cu umfassen, worin das in den inneren Elektrodenschichten enthaltene Cu in die piezoelektrischen Schichten diffundiert ist.

2. Laminiertes piezoelektrisches Element gemäß Anspruch 1, worin die piezoelektrische Keramikzusammensetzung 0,01 bis 0,8 Gew.% Cu, bezogen auf Cu₂O, umfasst.

3. Laminiertes piezoelektrisches Element gemäß Anspruch 1, worin die piezoelektrische Keramikzusammensetzung 0,02 bis 0,5 Gew.% Cu, bezogen auf Cu₂O, umfasst.

4. Laminiertes piezoelektrisches Element gemäß Anspruch 1, worin die piezoelektrische Keramikzusammensetzung 0,01 bis 0,4 Gew.% Ag, bezogen auf Ag₂O, umfasst.

5. Laminiertes piezoelektrisches Element gemäß Anspruch 1, worin die piezoelektrische Keramikzusammensetzung 0,02 bis 0,35 Gew.% Ag, bezogen auf Ag₂O, umfasst.

## Revendications

1. Élément piézoélectrique stratifié comprenant :
(a) une pluralité de couches piézoélectriques comprenant une composition de céramique piézo-électrique comprenant :
(i) en tant que constituant principal de celle-ci un oxyde composite représenté par la formule
(Pb_{a-b}Me_{b})[(Z_{n1/3}Nb_{2/3})ₓTi_{y}Zr_{z}]o₃
dans laquelle
0,96 ≤ a ≤ 1,03,
0 ≤ b ≤ 0,1,
0,05 ≤ x ≤ 0,15,
0,25 ≤ y ≤ 0,5,
0,35 ≤ z ≤ 0,6, et
x + y + z = 1, et
Me est au moins l'un parmi Sr, Ca et Ba ;
(ii) 0,01 à 1,0 % en poids de Cu en termes de Cu₂O par rapport à l'oxyde composite (i) ; et
(iii) 0,01 à 0,5 % en poids d'Ag en termes d'Ag₂O, par rapport à l'oxyde composite (i).
et
(b) une pluralité de couches d'électrodes internes formées entre les couches piézoélectriques et comprenant du Cu dans lesquelles le Cu contenu dans les couches d'électrodes internes a diffusé dans les couches piézoélectriques.

2. Élément piézoélectrique stratifié selon la revendication 1, dans lequel la composition de céramique piézoélectrique comprend de 0,01 à 0,8 % en poids de Cu en termes de Cu₂O.

3. Élément piézoélectrique stratifié selon la revendication 1, dans lequel la composition de céramique piézoélectrique comprend de 0,02 à 0,5 % en poids de Cu en termes de Cu₂O.

4. Élément piézoélectrique stratifié selon la revendication 1, dans lequel la composition de céramique piézoélectrique comprend de 0,01 à 0,4 % en poids d'Ag en termes d'Ag₂O.

5. Élément piézoélectrique stratifié selon la revendication 1, dans lequel la composition de céramique piézoélectrique comprend de 0,02 à 0,35 % en poids d'Ag en termes d'Ag₂O.
